# EUROPÄISCHE PATENTANMELDUNG

(11) **EP 0 532 845 A1**
(43) Veröffentlichungstag der Anmeldung: **24.03.1993**
(21) Anmeldenummer: 92111048.2
(22) Anmeldetag: 30.06.1992
(51) Int. Cl.: H01P 1/04, H01L 23/66

(54) **Träger für planare Mikrowellenschaltungen**

(30) Priorität: 17.09.1991 DE 4130925
(71) Anmelder: Daimler-Benz Aerospace Aktiengesellschaft, D-81663 München (DE)
(72) Erfinder: Uhland, Goebel. Dipl.-Ing., W-7916 Nersingen (DE)
(74) Vertreter: Schulze, Harald Rudolf, Dipl.-Ing.

(57) **Zusammenfassung**

Die Erfindung betrifft einen Träger für planare Mikrowellenschaltungen, mit einer metallischen oder zumindest an der Oberseite metallisierten Grundplatte (5a,5b), auf der mindestens ein Halbleiterchip (4a...4d) angeordnet ist, der über mindestens eine an der Chipoberseite angeordnete Anschlußstelle (6a,6b) mittels einer Bondverbindung (3a,3b) an mindestens einen weiteren Schaltungsteil angeschlossen ist. Um insbesondere Halbleiterchips mit standardisierten Anschlußstellen problemlos mit anderen Schaltungsteilen verbinden zu können, ohne dabei das zugehörige Layout der monolithisch integrierten Schaltung ändern zu müssen, wird nach der Erfindung vorgeschlagen, daß der mindestens eine weitere Schaltungsteil auf der Oberseite eines dielektrischen Substrats (2a,2b) angeordnet ist und eine die durch die Bondverbindung verursachte Störung kompensierende Anpaßschaltung enthält und daß das Substrat neben dem Halbleiterschip auf der Grundplatte angeordnet ist.

## Beschreibung

Die Erfindung betrifft einen Träger für planare Mikrowellenschaltungen gemäß dem Oberbegriff des Patentanspruchs 1. Ein solcher Träger ist beispielsweise aus der Firmenschrift "Hyper World" Nr. 2, Oktober 1990, Seiten 1 bis 6, der Firma Thomson Composants Microondes bereits bekannt.

Die Entwicklung monolithisch integrierter Schaltkreise auf Siliziumbasis ist weit fortgeschritten und erlaubt heutzutage sogar schon die monolithische Integration kompletter leistungselektronischer Schaltungen auf einem einzigen Silizium-Halbleiterchip. Diese Technologie stößt jedoch im Mikrowellenbereich wegen der relativ langsam ablaufenden elektronischen Prozesse im Silizium schnell an die Grenze ihrer Möglichkeiten.

Erst die Entwicklung monolithisch integrierter Schaltkreise auf der Basis der III/V-Verbindungen, insbesondere auf der Basis von Galliumarsenid (GaAs) bzw. Indiumphosphid (InP) half unter anderem wegen der größeren Elektronenbeweglichkeit in diesen Materialien, diese Grenze zumindest teilweise zu überwinden und ermöglicht heutzutage zwar noch nicht die monolithische Integration kompletter Schaltungen, jedoch die einzelner Schaltungssteile.

Der Aufbau kompletter Schaltungen für den Mikrowellenbereich, insbesondere für den Millimeterwellenbereich, sofern sie den derzeit erreichten Grad an monolithischer Integrationsfähigkeit überschreiten, wird im allgemeinen in Form von Hybriden realisiert. Bei dieser Technologie, die an sich ebenfalls aus der Entwicklung integrierter Schaltkreise auf Siliziumbasis bekannt ist, werden ein oder mehrere Halbleiterchips (mit den entsprechenden auf ihnen monolithisch integrierten Schaltungsteilen), gegebenenfalls auch weitere Schaltungsteile (wie. z. B. diskrete Bauelemente) auf einem gemeisamen Substrat oder einer gemeinsamen Platine angeordnet und über Verbindungsleitungen untereinander verbunden. Dabei werden die Halbleiterchips in der Regel nicht direkt auf die Platine aufgebracht, sondern auf separate Trägerplatten, die ihrerseits zum Aufbau der kompletten Schaltung auf der gemeinsamen Platine befestigt werden. Das Substrat mit der kompletten Schaltung wird anschließend in ein Gehäuse eingebracht und die Schaltung mit den entsprechenden am Gehäuse angebrachten Signalein- und -ausgängen verbunden.

Bei der Anwendung dieser Herstellungstechnologien auf integrierte Schaltkreise z. B. auf GaAs- bzw. InP-Basis für den Mikrowellenbereich treten jedoch Probleme auf, deren Auswirkungen im unteren Frequenzbereich bei integrierten Schaltkreisen auf Siliziumbasis im allgemeinen vernachlässigbar sind.

Zum einen hat sich gezeigt, daß es bei den im Vergleich zu den herkömmlichen integrierten Schaltkreisen (ICs) auf Siliziumbasis im allgemeinen weitaus dünneren und damit zerbrechlicheren ICs auf Galliumarsenidbasis entscheidend auf die richtige Wahl des Trägermaterials ankommt. Wie die in dem Artikel "Effects on coefficient of thermal expansion mismatch on solder attached GaAs MMICs" von J. Pavio und D. Hyde, in: IEEE MTT-S Digest, 1991, Sektion HH-5, Seiten 1075-1078 beschriebenen Untersuchungen ergaben, besteht bei GaAs-Chips, die infolge unterschiedlicher thermischer Ausdehnungskoeffizienten von Träger einerseits und GaAs-Chips andererseits unter Zugspannungsstreß stehen, eine weitaus höhere Bruchgefahr als bei GaAs-Chips, die aus demselben Grund unter Druckspannungsstreß stehen. Ausgehend von dem thermischen Ausdehnungskoeffizienten von Galliumarsendid, η(GaAs) ≈ 6,1 ppm/°C, führen nach diesen Untersuchungen bereits geringe Abweichungen des thermischen Ausdehnungskoeffizienten η des Trägermaterials zu kleineren Werten hin (z. B. η ≈ 5,1 ppm/°C für die bei Si-ICs häufin verwendete Meltallegierung Kovar) zu deutlich höheren Bruchraten, während bei Abweichungen des thermischen Ausdehnungskoeffizienten η des Trägermaterials zu größeren Werten hin erst bei Werten η > 16,5 ppm/°C ein merklicher Anstieg der Bruchrate auftrat.

Nach dieser Untersuchung sollte der thermische Ausdehnungskoeffizient des verwendeten Trägermaterials (Metall, Metallegierung oder metallisiserte Keramik) möglichst in dem Bereich 6,0 < η < 16,5 ppm/°C liegen. Neben den besonders geeigneten Keramikwerkstoffen Aluminiumnitrid (AlN) bzw. Berylliumoxid (BeO) kommen in verstärktem Maße auch sogenannte Metall-Matrix-Sinterwerkstoffe zur Anwendung, deren thermischer Ausdehnungskoeffizient, auf die individuellen Bedürfnisse über weite Bereiche einstellbar ist.

Ein weiteres Problem insbesondere bei der Anwendung der Hybrid-Technologie im Mikrowellenbereich besteht darin, die Verbindungsleitungen zwischen den einzelnen Schaltungsteilen möglichst kurz zu halten, da andernfalls die damit verbundenen zusätzlichen Serieninduktivitäten vor allem im Frequenzbereich oberhalb 12 GHz unerwünscht hohe Reflexionsfaktor- und Dämpfungswerte zur Folge haben.

Handelsübliche monolithisch integrierte Mikrowellen-schaltungen wie z. B. die im "Microwave Journal", Vol. 4, No. 4 (April 1991), Seite 53beschriebenen Schaltungen der Firma Microwave Technology oder die im "Microwave & RF" (Ausgust 1991) Seiten 25 beschriebenen Schaltungen der Firma CELERITEK eignen sich jedoch im allgemeinen nur für den Aufbau von geradlinigen Kettenschaltungen, bei denen die einzelnen, auf separaten Trägern aufgebrachten Schaltungen auf der Platine hintereinander aufgereiht werden mit der Folge, daß kurze Verbindungsleitungen nur zwischen direkt aufeinanderfolgenden Schaltungen möglich sind. Der Grund hierfür besteht darin, daß die Träger dieser Halbleiterchips auf zwei sich gegenüberliegenden Seiten Flanschverbindungen zum Anschrauben des Trägers auf der Platine aufweisen und diese Seiten somit ungeeignet sind, um auf verschiedenen Trägern aufgebrachte Halbleiterchips auf kürzestem Wege miteinander zu verbinden.

Um unter Verwendung solcher Träger dennoch Verbindung zwischen nicht direkt benachbarten Schaltungsteilen zu erreichen, sind entweder lange Bondverbindungen erforderlich oder es muß das Layout der auf den Trägern angebrachten Halbleiterchips geändert werden.

Es wurde auch schon vorgeschlagen, die Serieninduktivität der Verbindungsleitungen durch Verwendung breiter, flach anliegender Bondbänder oder mehrerer, flach anliegender und parallel angeordneter Bondbänder bzw. durch Minimierung des Montagespalts zwischen zwei benachbarten Trägern (bzw. Halbleiterchips) zu reduzieren. Die Folge war, daß trotz der hohen Anforderungen an die Fertigungs- und Positionierungstoleranzen Reproduzierbarkeit der einzelnen Verbindungen nur mangelhaft war, mit der weiteren Folge, daß einzelne Funktionseinheiten der Gesamtschaltung nur sehr schwer charakterisierbar waren.

Um definierte, reproduzierbare Verhältnisse zu schaffen, haben deshalb S. Nelson, M. Youngblood, J. Pavio, B. Larson und R. Kottmann in ihrem Artikel "Optimum Microship Interconnects", in: IEEE MTT-S Digest (1991), Sektion HH-4, Seiten 1071-1074 vorgeschlagen, statt flacher Bondverbindungen Bondverbindungen mit mehreren parallel angeordneten und nach oben gewölbten Bonddrähten konstanter Länge zu realisieren und die durch die Bondverbindung hervorgerufene Störung auf der Verbindungsleitung durch entsprechend unmittelbar sich an die Verbindung anschließende Leitungsabschnitte niedrigeren Wellenwiderstandes auf beiden Seiten der Bondverbindung zu kompensieren.

Die Aufgabe der Erfindung besteht darin, einen Träger anzugeben, der eine Erstellung vorabgeglichener Funktionseinheiten aus monolithisch integrierten Mikro- bzw. Millimeterwellenschaltungen ohne Änderung des Layouts dieser Schaltungen auf wärmeleitenden Grundflächen mit standardisierter Anschlußgeometrie ermöglicht, welche einen möglichst kompakten Aufbau kompletter Schaltungen ermöglicht und die Anwendung von herkömmlichen Bondverfahren gestattet.

Die erfindungsgemäße Lösung dieser Aufgabe ist durch die kennzeichnenden Merkmale des Patentanspruchs 1 wiedergegeben; die Unteransprüche enthalten vorteilhafte Aus- und Weiterbildungen der Erfindung.

In einer bevorzugten Ausbildung der Erfindung werden der oder die Halbleiter auf einem metallischen oder metallisierten Träger zusammen mit einem ring- oder gabelförmigen dielektrischen Substrat, welches Anpaß- (Kompensations-) Schaltungen und beliebige weitere Schaltungselemente trägt, aufgebracht, wobei die durch die Bondverbindung zwischen Chip und Verbindungssubstrat entstehende Störstello durch eine Tiefpaß-, Bandpaß- (oder Hochpaß-) Filterstruktur auf dem Verbindungssubstrat kompensiert wird (standardisierbar pro Kombination von Chip und Substrat bezüglich Dicken und Dielektrizitätskonstante und der oberen Frequenzgrenze) sowie die Verbindungsstelle zwischen den Trägern durch symmetrisch aufgeteilte planare Schaltungen vorabgeglichen werden, welche durch das Verbindungselement (Bonddraht, Bändchen etc.) zu einem reflexionsarm angepaßten Filternetzwerk (TP, BP, HP) ergänzt werden. Vorzugsweise im Bereich der Trägerecken werden durch geeignete Ausklinkungen aus dem Verbindungssubstrat und dem Träger präzise Angriffspunkte für Handhabungswerkzeuge sowie für Befestigungselemente (vorzugsweise Klemmfedern oder -bolzen) geschaffen.

Die Erfindung hat folgende wesentliche Vorteile:
- gute Wärmeableitung von den Chips;
- Kompensation der Bondverbindungen, sowohl an internen als auch an externen Verbindungsstellen;
- Unempfindlichkeit gegen mechanische Toleranzen;
- minimaler Platzbedarf;
- flexible Lage der Anschlußpunkte;
- keine Veränderung des Chip-Layout;
- Vermeidung von Spalten in der Masseverbindung;
- die vormontierten Funktionseinheiten (mit internen Bondverbindungen) können präzise in standardisierten Meßfassungen chakarterisiert werden;
- sie können umfangreichen Funktionsprüfungen ("burn in", Temperaturzyklen etc.) unterworfen und dabei meßtechnisch reproduzierbar überwacht werden;
- geeignete Module können gegebenenfalls über Rechnersimulation der Systemfunktion ausgewählt und in Subsystemen zusammengestellt werden;
- Anwendbarkeit bewährter Verbindungstechnologie (weitgehend verfügbar, auch vollautomatisch);
- Unempfindlichkeit gegenüber mechanischen Toleranzen, Temperaturdehnungseffekten (definierter; nicht zu flacher "Bondloop").

Im folgenden wird die Erfindung anhand der Figuren näher erläutert. Es zeigen:
- FIG. 1: einen Ausschnitt aus einer schematisch gezeichneten Hybrid-Mikrowellenschaltung in der Draufsicht mit mehreren bevorzugten Ausführungsformen des erfindungsgemäßen Trägers;
- FIG.2: ein Detail der Mikrowellenschaltung gemäß FIG.1 mit einer Verbindung zwischen zwei Trägern nach einer besonderen Ausbildung der Erfindung;
- FIG.3: einen Schnitt der Mikrowellenschaltumg gemäß FIG. 1 entlang der Linie AA im Ausschnitt;
- FIG. 4-5: eine bevorzugte Ausführungsform der Bondverbindung zwischen Halbleiterchip und Substrat auf einem Träger nach der Erfindung im Querschnitt (FIG. 4) und in der Draufsicht (FIG.5);
- FIG. 6-7: eine bevorzugte Ausführungsform der Bondverbindung zwischen zwei Trägern nach der Erfindung im Querschnitt (FIG.6) und im Ersatzschaltbild (FIG.7) für die halbe Bondverbindung;
- FIG. 8-9: eine bevorzugte Ausbildung der Befestigungsvorrichtung für die Träger nach der Erfindung auf einer Basisplatte für die Hybride-Mikrowellenschaltung im Querschnitt (FIG. 8) und in der Draufsicht (9);
Der Ausschnitt aus einer schematisch gezeichneten Mikrowellenschaltung (FIG. 1) auf hybrider Basis (ohne die im Zusammenhang mit der Erfindung unwesentlichen Funktionsangaben der einzelnen Halbleiter(chips) zeigt in der Draufsicht mehrere bevorzugte Ausführungsformen des erfindungsgemäßen Trägers.

Dabei ist mit der Bezugsziffer 1 (bzw. 1a, 1b) der mindestens eine weitere Schaltungsteil auf der Oberseite des dielektrischen Substrats 2 (bzw. 2a, 2b) bezeichnet, der durch eine Bondverbindung 3 (bzw. 3a, 3b) mit der zugehörigen (standardmäßigen) Anschlußstelle 6 (bzw. 6a, 6b) auf dem Halbleiterchip 4 (bzw. 4a, 4b, 4c, 4d) verbunden ist. Der weitere Schaltungsteil 1 (1a, 1b) enthält dabei eine die durch die Bondverbindung 3 verursachte Störung kompensierende Anpaßschaltung. Das Substrat 2 (2a, 2b) und der Halbleiterchip 4 (4a, 4b, 4c, 4d) wird dabei auf der Oberseite einer metallischen oder zumindest auf der Oberseite metallisierten Grundplatte 5 (bzw. 5a, 5b) angeordnet.

Auf der Grundplatte 5b sind zwei Halbleiterchips 4b und 4c aufgebracht, die in entsprechenden rahmenförmigen Aussparungen im Substrat 2b eingepaßt sind. Auf dem Substrat ist ferner eine Steuer- und Stromversorgungseinheit 26, beispielsweise auf Dünnfilmschaltung auf das Substrat 2b aufgebracht und mit dem entsprechenden Anschluß auf dem Halbleiterchip 4b verbunden. Die Halbleiterchips 4b und 4c sind über eine kompensierte Chip-zu-Chip-Verbindungsleitung 27 miteinander verbunden. Mit 28 ist die Gehäuse-Seitenwand bezeichnet. Mit 29 ist eine Durchverbindung mit den erfindungsgemäßen weiteren Bondverbindungen 9 einschließlich der zugehörigen weiteren Anpaßschaltungen 80 gezeigt. Bei dieser Durchverbindung 29 dient der zugehörige Träger lediglich dazu, eine definierte und kompensierte Verbindung zwischen Schaltungsteilen, die auf anderen Trägern angeordnet sind, herzustellen.

Die Ecken 13 der rechteckförmigen Trägergrundplatte 5, 5b, 5 sind unter einem Winkel von 45° abgeschnitten. Die Substrate 2a, 2b, 2 weisen in diesem Bereich kreisförmige Aussparungen 20 auf. Dadurch bildet sich zwischen den einzelnen Trägern ein Zwischenraum, in dem ein Stift 14 zur Befestigung der Träger an der Basisplatte 15 befestigt werden kann.

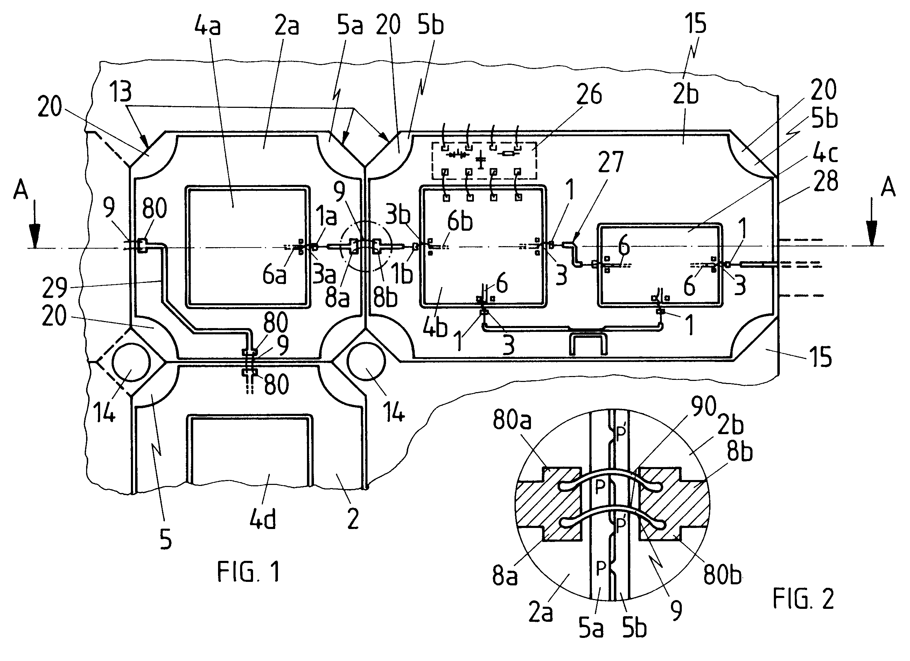

Wie FIG. 2 im Ausschnitt zeigt, sind die einzelnen Träger über weitere Bondverbindungen 9 miteinander verbunden. Die Verbindungsstellen 8a, 8b dieser weiteren Bondverbindungen 9 enthalten jeweils eine die durch die Bondverbindung 9 hervorgerufene Störung kompensierende Anpaßschaltung 80a, 80b in Form einer zum freien Ende sich seitlich symmetrisch erweiternden Streifenleitung (im Beispiel in Form eines symmetrischen Hammerkopfes). Die weitere Bondverbindung 9 besteht dabei aus zwei parallel zueinander und symmetrisch bezüglich des Spaltes zwischen den beiden Substraten 2a, 2b angeordneten Bonddrähten 90.

Die Seitenflächen der Grundplatte 5a, 5b der beiden Träger weisen zumindest im Bereich der weiteren Bondverbindungen etwa senkrecht verlaufende Stege P bzw P' auf, die gegeneinander versetzt angeordnet sind und deren Berührungspunkte mit der jeweils anderen Trägergrundplatte einen Abstand aufweisen, der sehr viel kleiner ist als die halbe Wellenlänge der oberen Grenzfrequenz der Mikrowellenschaltung.

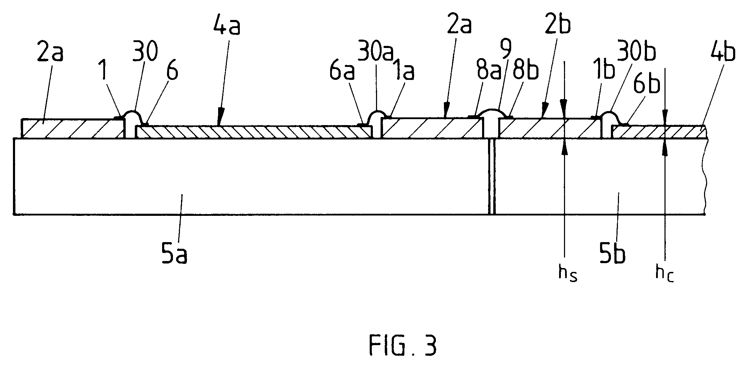

Der in FIG. 3 gezeigte Schnitt der Mikrowellenschaltung gemäß FIG. 1 entlang der (dort eingezeichneten) Linie AA im Ausschnitt zeigt zwei Träger nach der Erfindung. Auf der Grundplatte 5a bzw. 5b des jeweiligen Trägers ist jeweils ein Halbleiterchip 4a, bzw. 4b aufgebracht (z. B. durch löten oder kleben); er ist umgeben von einem dielektrischen Substrat 2a bzw. 2b. Die (standardmäßig vorgesehenen) Anschlußstellen 6 bzw. 6a oder 6b auf dem Halbleitercip 4a bzw. 4b sind über Bondverbindungen 30, 30a bzw. 30b mit den die Anpaßschaltung enthaltenden Schaltungsteilen 1, 1a bzw. 1b verbunden. Die Chipdicke beträgt etwa 60 % der Substratdicke.

Die beiden Träger sind über eine weitere Bonddrahtverbindung 9 verbunden. Die Verbindung besteht aus zwei parallel angeordneten und nach oben gewölbten Bonddrähten, die mit ihren Enden jeweils an einer Verbindungsstelle 8a bzw. 8b auf dem zugehörigen Substrat 2a bzw. 2b mit der Verbindungsleitung zu der jeweiligen Anpaßschaltung 1a bzw. 1b verbunden.

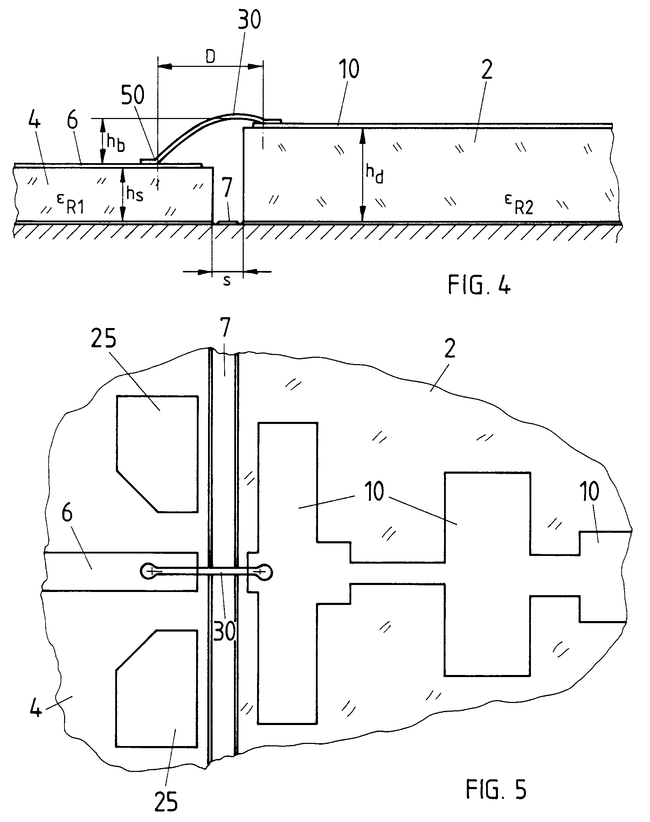

Die in den Figuren 4 und 5 gezeigten bevorzugten Ausführungsformen der Bondverbindung zwischen Halbleiterchip und Substrat auf einem Träger nach der Erfindung (im Querschnitt) ist ausschnittsweise der Halbleiterchip 4 (mit der Dielektrizitätskonstanten ε_{R1}) mit der Anschlußstelle 6 zu sehen sowie das im umgebenden Substrat 2 (mit der Dielektrizitätskonstanten ε_{R2}) mit der Anpaßschaltung 10 auf der Substrat-Oberseite. Die Dicke des Chip 4 ist mit hₛ, die Dicke des Substrats 2 ist mit h_{d} bezeichnet. In FIG. 5 ist die Bonddrahtverbindung 30 gemäß FIG. 4 in der Draufsicht gezeigt. Mit 6 ist die Anschlußstelle auf dem Halbleiterchip 4 bezeichnet, mit 10 die Anpaßschaltung auf dem Substrat 2 in Form einer Tiefpaßfilterstruktur mit durch die Bonddrahtgeometrie vorgegebenem ersten induktiven Serienelement; das Filter ist vorzugsweise an beiden Enden an 50 Ω angepaßt (es kann aber auch an unterschiedliche Wellenwidertandswerte z. B. 50 Ω einerseits und 75 Ω andererseits angepaßt werden). Mit 25 sind standardmäßig auf dem Halbleiterchip 4 vorgesehene Masseflecken zur Charakterisierung der Schaltung auf dem Wafer bezeichnet.

Der Chip 4 ist durch einen Spalt S vom Substrat 2 getrennt. In Spalt S auf der Oberseite der Grundplatte ist umlaufend zu dem Chip 4 ein Rahmen in Form einer Lötstopmaske 7 angeordnet. Dies gewährleistet eine quasi automatische Zentrierung des Chips beim Lötprozeß, vor allem dann, wenn das Lot mit genau bemessenem Volumen, beispielsweise in Form einer Lotfolie aufgebracht wird.

Bei der Bonddrahtgeometrie in diese Ausführungsform ist die Lokalisierung der Befestigungsstelle 50 des Drahtes 30 auf der Anschlußstelle 6 auf dem Chip 4 im wesentlichen unkritisch in bezug auf die Dimensionsierung der Ausgangsschaltung 10; kristisch dagegen ist die Einhaltung der Bogenhöhe h_{B} des Bonddrahtes in bezug auf diese Dimensionierung.

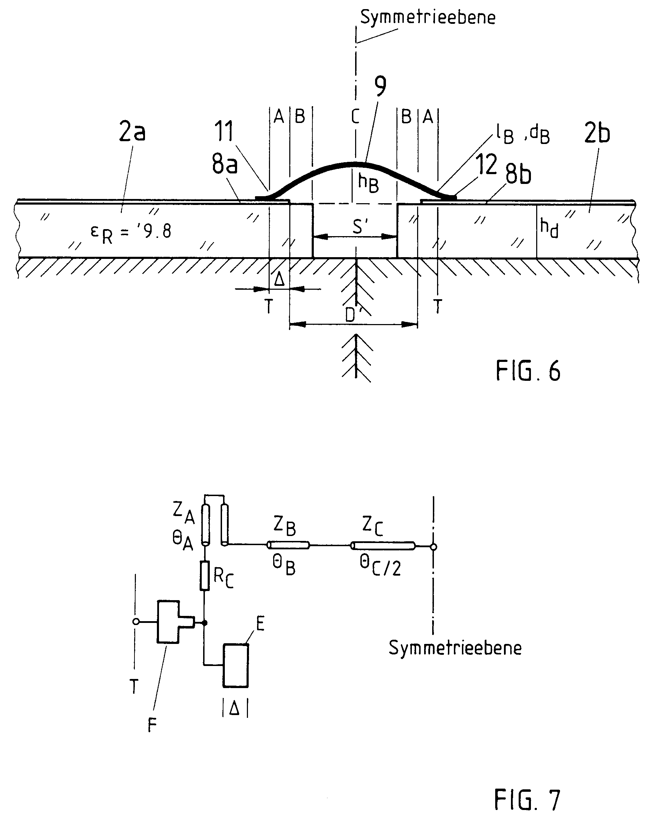

Die in FIG. 6 gezeigte bevorzugte Ausführungsform der weiteren Bondverbindung zwischen zwei benachbarten Trägern nach der Erfindung zeigt im Querschnitt die beiden Substrate (mit der Dielektrizitätskonstante ε_{R} = 9,8) 2a und 2b, die an den Verbindungsstellen 8a und 8b über die Bonddrahtverbindung 9 (bestehend z. B. aus zwei oder drei parallel angeordneten und nach oben gewölbten Bonddrähten) verbunden sind. Die Verbindungsstellen 8a und 8b enthalten jeweils die Hälfte oder zumindest annähernd die Hälfte der (unter Einbeziehung der Bondverbindungsparameter dimensionierten) Anpaßschaltung, welche die durch die Bondverbindung verursachte Störung gemeinsam kompensieren. Mit 11 bzw. 12 sind dabei die Befestigungspunkte der Bondverbindung auf der jeweiligen Verbindungsstelle 8a und 8b bezeichnet, mit l_{B} die Länge, mit d_{B} die Dicke und mit h_{B} die Bogenhöhe der Bonddrähte bezeichnet, h_{d} bezeichnet die Dicke der beiden Substrate 2a, 2b, D bezeichnet den Abstand der freien Enden der beiden Verbindungsstellen 8a, 8b; Δ bezeichnet den Abstand der freien Enden der beiden Verbindungsstellen von zugehörigen Befestigungspunkt 11, 12 der Bondverbindung 9.

Die Bondverbindung 9 ist bezüglich der in der Figur eingezeichneten Symmetrieebene symmetrisch ausgebildet; die Buchstaben A, B, C und T markieren Teilabschnitte bzw. Aufpunkte der Bondverbindung, die ihre Entsprechung in dem Ersatzschaltbild (der halben Bondverbindung!) in FIG. 7 haben. In dem Ersatzschaltbild in FIG. 7 sind die Wellenwiderstände der einzelnen Teilabschnitte A, B und C/2 mit Z bezeichnet und die Phasenwinkel des Transmissionsfaktors bei der Entwurfsfrequenz der gleichen Teilabschnitte mit ϑ. E bezeichnet die Nachbildung des offenen Endes der Verbindungsstelle 8a der Länge Δ; F bezeichnet die Nachbildung eines Sprungs in der Leiterbreite beim Übergang von der Streifenleitung der Verbindungsstelle auf den Bonddraht der Bondverbindung. Mit Rc ist der kombinierte ohmsche Widerstand der Verbindungsstelle 8a und des halben Bonddrahtes bezeichnet.

Bei der Dimensionierung der beidseitigen Anpaßschaltungen ist besonders kritisch die Einhaltung der dieser Dimensionierung zugrunde liegenden geometrischen Anordnung der Bondverbindung.

Besonders wichtig ist dabei die Einhaltung der Bonddrahtlänge (l_{B}) und der Bonddraht c Bogenhöhe (h_{B}), wobei die mittels der Anpaßschaltungen vorgenommene Kompensation der durch die Bondverbindung hervorgerufnene Störung etwa zweimal so empfindlich auf Abweichung in der Drahtlänge l_{B} reagiert wie auf Abweichungen in der Drahtbogenhöhe h_{B}. Durch eine geeignete Auslegung des Anpaßschaltungslayours in der näheren Umgebung der Befestigungspunkte 11, 12 wird die Bondverbindung 9 unempfindlich gegen Abweichungen der Substrate 2a, 2b von ihrer Sollposition, sofern die Bonddrahtgeometrie (D, h_{B}, l_{B}) konstant gehalten wird.

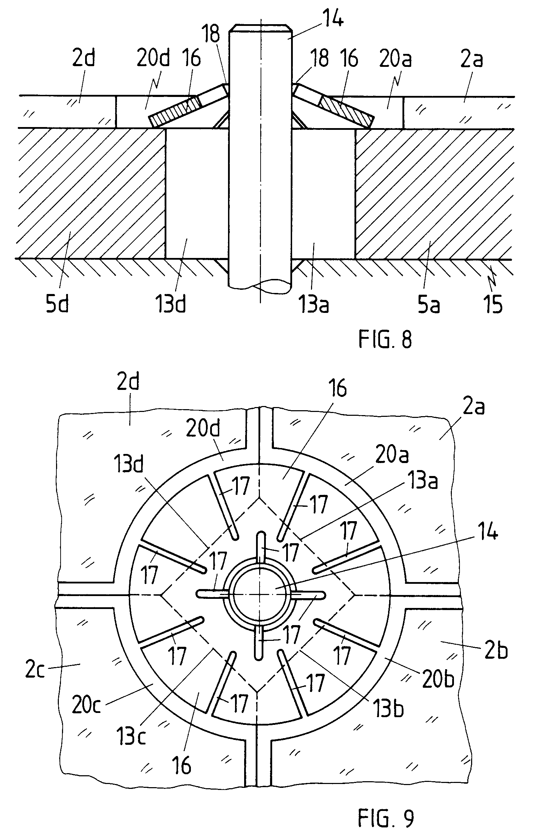

In den Figuren 8 und 9 ist eine bevorzugte Ausbildung der Befestigungsvorrichtung für die Träger nach der Erfindung auf der Basisplatte für hybride Mikrowellenschaltungen im Querschnitt (FIG. 8) und in der Draufsicht (FIG. 9) gezeigt.

In beiden Figuren ist mit 15 die Basisplatte für die hybride Mikrowellenschaltung, mit 13a-d die (abgeschnittenen) Ecken der Grundplatten 5a-5d der einzelnen Träger; mit 2a-d die Substrate, mit 20a-d die kreisbogenförmigen Aussparungen in den Substraten im Bereich der (abgeschnittenen) Ecken 13a-d der Grundplatten 5a-d der einzelnen Träger bezeichnet. Mit 14 ist der in der Basisplatte 15 zu verankernde Befestigungsstift mit kreiszylindrischem Querschnitt bezeichnet und mit 16 der kegelförmig nach oben gestülpte Klemmring bezeichnet, dessen entspannter Innendurchmesser kleiner gewählt ist als der Durchmesser des Befestigungsstifts 14 und dessen Außendurchmesser kleiner gewählt ist als der Durchmesser des durch die kreisbogenförmigen Aussparungen 20a-d umschriebenen Kreises. Die Innenkante 18 des Klemmrings 16 ist als Schneidkante ausgebildet, die sich beim Überstülpen in den Befestigungsstift 14 einschneidet. Der Klemmring 16 weist von der Außenkante etwa radial nach innen und von der Innnenkante etwa radial nach außen weisende Einschnitte 17 auf. Die inneren Einschnitte haben zur Aufgabe, die zum Überstülpen über den Stift 14 erforderliche Verformung zu gestatten, während die äußeren Einschnitte eventuell bestehende Dickenunterschiede der einzelnen Trägergrundplatten ausgleichen.

Die Erfindung ist nicht auf die beschriebenen Ausführungsbeispiele beschränkt, sondern sinngemäß auf weitere anwendbar. Beispielsweise ist es möglich, durch Festlegung der Trägerabmessungen parallel zur Schaltungsebene auf ein geeignet gewähltes Rastermaß trotz standardisierter Positionen der Anschlußstellen (8, 8a, 8b in FIG. 1) und damit vereinfachtem meßtechnischem Zugang in entsprechenden Mikrowellen-Testfassungen einen hohen Grad von Flexibilität im Mikrowellen-Subsystem-Layout zu erreichen.

## Patentansprüche

1. Träger für planare Mikrowellenschaltungen, mit einer metallischen oder zumindest an der Oberseite metallisierten Grundplatte, auf der mindestens ein Halbleiterchip angeordnet ist, der über mindestens eine an der Chipoberseite angeordnete Anschlußstelle mittels einer Bondverbindung an mindestens einen weiteren Schaltungsteil angeschlossen ist, dadurch gekennzeichnet, daß der mindestens eine weitere Schaltungsteil (1) auf der Oberseite eines dielektrischen Substrats (2) angeordnet ist und eine die durch die Bondverbindung (3) verursachte Störung kompensierende Anpaßschaltung (10) enthält und daß das Substrat (2) neben dem Halbleiterchip (4) auf der Grundplatte (5) angeordnet ist.

2. Träger nach Anspruch 1, dadurch gekennzeichnet, daß die Anpaßschaltung (10) sich unmittelbar an die Bondverbindung (3) anschließt und der Anschlußstelle (6) vorzugsweise direkt gegenüber auf dem Substrat (2) angeordnet ist.

3. Träger nach einem der Ansprüche 1 oder 2, dadurch gekennzeichnet, daß die Anpaßschaltung (10) in Form einer vorzugsweise in Streifenleitungstechnik realisierten Tiefpaß-, Bandpaß- oder Hochpaß-Filterstruktur realisiert ist.

4. Träger nach einem der vorhergehenden Ansprüche, dadurch gekennzeichnet, daß die Bondverbindung (3) in Form eines nach oben gewölbten Bondbandes oder -drahtes (30) oder in Form mehrerer parallel angeordneter und nach oben gewölbter Bondbänder und/oder -drähte mit vorzugsweise gleicher oder zumindest annähernd gleicher Bogenlänge (l_{B}) und/oder Bogenhöhe (h_{B}) realisiert ist.

5. Träger nach einem der vorhergehenden Ansprüche, dadurch gekennzeichnet, daß die Anschlußstelle (6) und/oder die Anpaßschaltung (10) (jeweils) an ihrem freien Ende seitlich symmetrisch aufgeweitet ist (sind).

6. Träger nach einem der vorhergehenden Ansprüche, dadurch gekennzeichnet, daß das Substrat (2) den Halbleiterchip (4) in Form eines zumindest teilweise geschlossenen Rahmens mit vorzugsweise parallel oder zumindest annähernd parallel zu den Chipkanten verlaufenden Innenkanten zumindest teilweise umgibt.

7. Träger nach Anspruch 6, dadurch gekennzeichnet, daß der Abstand (S) zwischen den Innenkanten des Substrats (2) und den Außenkanten des Halbleiterchips (4) konstant oder zumindest annähernd konstant ist.

8. Träger nach einem der Ansprüche 6 oder 7, dadurch gekennzeichnet, daß die Dicke (hₛ) des Halbleiterchips (4) geringer ist als die Dicke (h_{d}) des ihn umgebenden ersten Substrats (2) und dabei vorzugsweise einen Wert aus dem Bereich von etwa 20-90 %, insbesondere aus dem Bereich von etwa 40-70 %, insbesondere von etwa 60 % der Substratdicke (h_{c}) annimmt.

9. Träger nach einem der vorhergehenden Ansprüche, dadurch gekennzeichnet, daß der mindestens eine Halbleiterchip (4) auf Galliumarsenid (GaAs)- oder Indiumphosphid (InP)- oder Silizium (Si)-Basis gefertigt ist.

10. Träger nach einem der vorhergehenden Ansprüche, dadurch gekennzeichnet, daß das Substrat (2) aus Aluminiumoxid (Al₂O₃) oder Berylliumoxid (BeO) oder Aluminiumnitrid (AlN) oder Saphir oder Quartz oder gefülltem Polytetrafluorethylen (PTFE) besteht.

11. Träger nach einem der vorhergehenden Ansprüche, dadurch gekennzeichnet, daß die Grundplatte (5) aus Keramik, vorzugsweise aus Aluminiumnitrid (AlN) oder Berylliumoxid (BeO), mit metallisierter Oberfläche besteht oder aus Metall oder aus einer Metallegierung oder aus einem Metall-Matrix-Sinterwerkstoff besteht.

12. Träger nach Anspruch 11, dadurch gekennzeichnet, daß der thermische Ausdehnungskoeffizent η_{G} des Grundplattenmaterials größer oder gleich ist dem thermischen Ausdehnungskoeffizienten η_{c} des Halbleiterchipmaterials und bei Halbleiterchips auf Galliumarsenid(GaAs)-Basis vorzugsweise einen Wert aus dem Bereich 6,0<η_{G}<20,0 ppm/°C, insbesondere aus dem Bereich 6,5<η_{G}<13,0 ppm/°C, insbesondere aus dem Bereich 6,5<η_{G}<10,5 ppm/°C, insbesondere aus dem Bereich 6,5<η_{G}<7,5 ppm/°C hat.

13. Träger nach einem der vorhergehenden Ansprüche, dadurch gekennzeichnet, daß der Halbleiterchip (4) auf die Grundplatte (5) gelötet oder geklebt ist.

14. Träger nach Anspruch 13, dadurch gekennzeichnet, daß das Lot ein Indium(In)-Lot oder ein Gold-Zinn(AuSn)-Lot ist bzw. der Kleber ein vorzugsweise mit Gold (Au) oder Silber (Ag) gefülltes Epoxidharz ist.

15. Träger nach einem der vorhergehenden Ansprüche, bei welchem der Halbleiterchip auf die Grundplatte gelötet ist, dadurch gekennzeichnet, daß auf der Grundplatte (5) um den Halbleiterchip (4) herum ein aus nicht vom verwendeten Lot benetzbarem Material, vorzugsweise Lötstoplack, bestehender Streifen (7) angebracht ist und daß das Lot vorzugsweise in Form einer Lotfolie zwischen Grundplatte (5) und Halbleiterchip (4) eingebracht ist.

16. Träger nach einem der vorhergehenden Ansprüche, zum Anschluß an mindestens einen weiteren Träger nach einem der vorhergehenden Ansprüche, dadurch gekennzeichnet,
- daß am äußeren Rand der Oberseite des Substrats (2a) mindestens eine erste Verbindungsstelle (8a) angeordnet ist;
- daß die erste Verbindungsstelle (8a) über eine weitere Bondverbindung (9) mit einer gleichartigen zweiten Verbindungsstelle (8b) verbunden ist, welche am äußeren Rand der Oberseite des Substrats (2) des zweiten Trägers angeordnet ist;
- daß die erste Verbindungsstelle (8a) eine die durch die weitere Bondverbindung (9) verursachte Störung zur Hälfte oder zumindest annähernd zur Hälfte kompensierende weitere Anpaßschaltung (80a) enthält und daß die zweite Verbindungsstelle (8b) auf dem zweiten Träger eine diese Störung ebenfalls zur Hälfte oder zumindest annähernd zur Hälfte kompensierende zweite Anpaßschaltung (80b) enthält.

17. Träger nach Anspruch 16, dadurch gekennzeichnet, daß die weitere Anpaßschaltung (80a) (bzw. die zweite Anpaßschaltung (80b)) sich (jeweils) unmittelbar an die weitere Bondverbindung (9) anschließt und daß die beiden Verbindungsstellen (8a, 8b), durch einen Spalt (S') zwischen den Substraten (2a, 2b) der beiden Träger getrennt, sich direkt gegenüber stehen.

18. Träger nach einem der Ansprüche 16 oder 17, dadurch gekennzeichnet, daß die weitere (und/oder die zweite) Anpaßschaltung (80a; 80b) in Form einer vorzugsweise in Streifenleitungstechnik realisierten Tiefpaß- oder Bandpaß- oder Hochpaß-Filterstruktur realisiert ist.

19. Träger nach einem der Ansprüche 16 bis 18, dadurch gekennzeichnet, daß der Abstand (Δ) der beiden Befestigungsstellen (11; 12) der weiteren Bondverbindung (9) vom freien Ende der jeweils zugehörigen Verbindungsstelle (8a; 8b) für beide Befestigungsstellen (11; 12) gleich oder zumindest annähernd gleich ist.

20. Träger nach einem der Ansprüche 16 bis 19, dadurch gekennzeichnet, daß die weitere Bondverbindung (9) in Form eines nach oben gewölbten Bondbandes oder -drahtes oder in Form mehrerer parallel angeordneter und nach oben gewölbter Bondbänder- und/oder -drähte (90) mit vorzugsweise gleicher oder zumindest annähernd gleicher Bogenlänge (l_{B}) und/oder Bogenhöhe (h_{B}) realisiert ist.

21. Träger nach einem der Ansprüche 16 bis 20, dadurch gekennzeichnet, daß die beiden Verbindungsstellen (8a; 8b) an ihrem freien Ende jeweils seitlich symmetrisch aufgeweitet sind, vorzugsweise in Form eines symmetrischen Hammerprofils.

22. Träger nach einem der Ansprüche 16 bis 21, dadurch gekennzeichnet, daß zumindest im Bereich der Verbindungsstelle (8a; 8b) die äußere Kante des Substrats (2a; 2b) parallel oder zumindest annähernd parallel zur Grundplattenkante verläuft und daß der Abstand (S/2) zwischen äußerer Substratkante und Trägerkante insbesondere konstant ist und vorzugsweise in etwa übereinstimmt mit dem Abstand (AB; BA) zwischen der zugehörigen Befestigungsstelle (11; 12) der weiteren Bondverbindung (9) und äußerer Substratkante.

23. Träger nach einem der vorhergehenden Ansprüche, dadurch gekennzeichnet, daß die Grundplatte (5) ein Vieleck mit vorzugsweise rechtwinkligen oder zumindest annähernd rechtwinkligen Ecken, vorzugsweise ein Rechteck oder Quadrat, darstellt und daß die Seitenflächen der Grundplatten (5) vorzugsweise zumindest im Bereich von Verbindungsstellen (8a; 8b) mehrere senkrecht verlaufende, gleichartige und beispielsweise mittels eines Funkenerosionsprozesses hergestellte Stege (P; P') mit planparallel zur Seitenfläche der Grundplatte (5) verlaufenden Stirnflächen aufweist.

24. Träger nach Anspruch 23, dadurch gekennzeichnet, daß der seitliche Abstand zwischen durch benachbarte Stege (P; P') gebildeten Kontaktstellen sehr viel kleiner ist als die halbe Wellenlänge der oberen Grenzfrequenz der Schaltung und daß die Stege (P; P') benachbarter Träger gegeneinander versetzt an den Seitenflächen angeordnet sind.

25. Träger nach einem der Ansprüche 23 bis 24, dadurch gekennzeichnet, daß die Ecken (13) der Grundplatte (5) entlang der Hypothenuse eines gleichschenklig rechtwinkligen oder zumindest annähernd gleichschenklig rechtwinkligen Dreiecks mit einem durch den Schnittpunkt benachbarter Grundplattenkanten aufgespannten rechten oder zumindest annähernd rechten Winkel unter einen Winkel von 45° oder zumindest annähernd 45° abgeschnitten sind.

26. Träger nach Anspruch 25, dadurch gekennzeichnet, daß das Substrat (2) im Bereich der einzelnen Ecken (13) der Grundplatte (5) jeweils eine Aussparung (20) aufweist.

27. Träger nach Anspruch 26, dadurch gekennzeichnet, daß die Aussparung (20) kreisbogenförmig verläuft mit dem Schnittpunkt der benachbarten Kanten der Grundplatte (5) als Kreismittelpunkt und einem Radius, der größer ist als die Länge der abgeschnittenen Katheten des durch die Ecke der Grundplatte (5) aufgespannten gleichschenkligen rechtwinkligen Dreiecks.

28. Vorrichtung zum Befestigen eines oder mehrerer Träger nach einem der Ansprüche 25 bis 27 auf einer gemeinsamen Basisplatte, dadurch gekennzeichnet,
- daß an den Ecken (13) des Trägers jeweils ein Stift (14) mit kreiszylindrischem Querschnitt in der Basisplatte (15) befestigt ist;
- daß über den Stift (14) ein Klemmring (16) gestülpt ist, dessen Innendurchmesser geringfügig kleiner ist als der Durchmesser des Stiftes (14), und dessen Außendurchmesser geringfügig kleiner ist als der Durchmesser des zu der kreisbogenförmigen Aussparung (20) zugehörenden Kreises und der von der Außenkante radial nach innen und von der Innenkante radial nach außen weisende Einschnitte (17) aufweist.

29. Vorrichtung nach Anspruch 28, dadurch gekennzeichnet, daß die Innenkante (18) des vorzugsweise kegelförmig aufgestülpten Klemmrings (16) als Schneidkante ausgebildet ist.
